# EUROPEAN PATENT SPECIFICATION

(11) **EP 0 465 668 B1**
(45) Date of publication and mention of the grant of the patent: **01.05.1996**
(21) Application number: 91902792.0
(22) Date of filing: 28.01.1991
(51) Int. Cl.: H03F 3/45, G11B 5/02

(54) **HEAD AMPLIFIER**
LESEKOPFVERSTÄRKER
AMPLIFICATEUR DE TETE DE LECTURE

(30) Priority: 29.01.1990 JP 18634/90
(43) Date of publication of application: 15.01.1992
(73) Proprietor: SANYO ELECTRIC CO., LTD., Moriguchi-shi, Osaka 570 (JP)
(72) Inventor: ANZAI, Fukuji, Sanyo Electric Co., Ltd., Osaka 570 (JP)
(74) Representative: Glawe, Delfs, Moll & Partner
(86) International application number: PCT/JP91/00091
(87) International publication number: WO 91/11803

(56) References cited:
- EP-A- 0 300 494
- JP-A- 6 376 510
- PATENT ABSTRACTS OF JAPAN, vol. 7, no. 15 (P-169), 21st January 1983; & JP-A-57 169 909

## Description

### FIELD TO WHICH THE INVENTION IS PERTINENT

The present invention relates to a head amplifier for home VTR, more specifically, to a head amplifier suitable for integration into an IC.

### BACKGROUND TECHNOLOGY

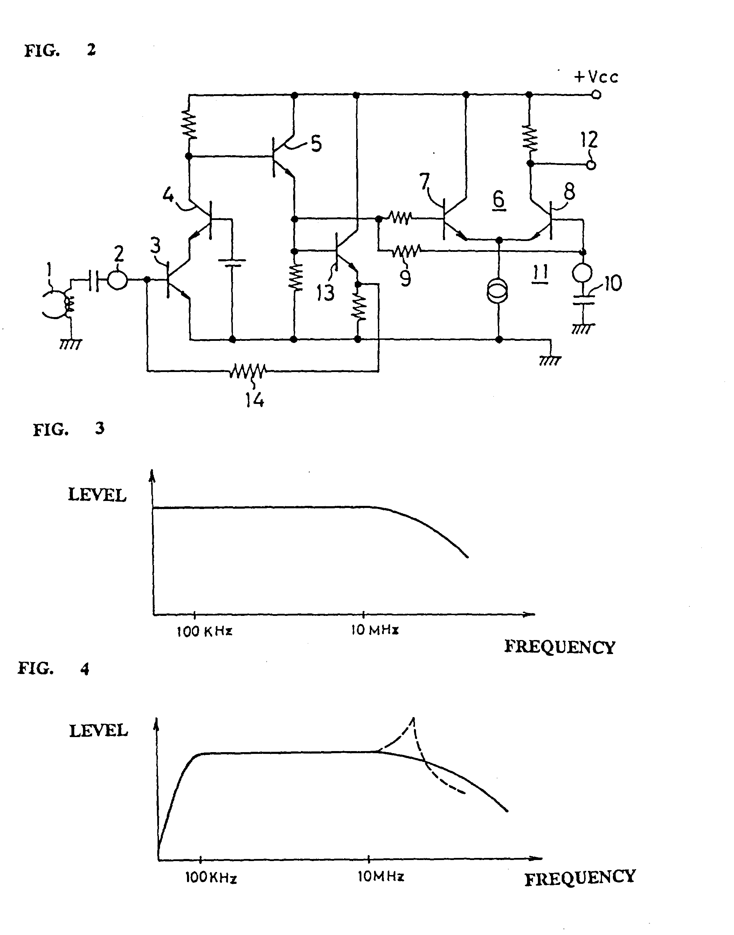

A head amplifier is an amplifier of a home VTR to which a playback signal from a magnetic head is first supplied. A head amplifier installed in an IC is already known, for example, from Japanese Laid-Open Publication No. 55-153108 the circuit of which is exhibited in Fig.2.

Another example is shown in Japanese Laid-Open Publication No.57-169909.

In Fig.2, a playback signal from a video head 1 is sent to the base of a grounded-emitter transistor 3 installed in an IC through an input pin 2 where the signal is amplified and output to the collector of a grounded-base transistor 4 which is connected in cascade with grounded-emitter transistor 3. The amplified playback signal is further sent through a first buffer transistor 5 to the bases of transistors 7 and 8 that form a differential amplifier 6. Alternative signal components of the output playback signal from first buffer transistor 5 are reduced to a DC component at the base of transistor 8 by a smoothing circuit 11 comprising a resistor 9 and capacitor 10 while at the base of transistor 7 the playback signal is amplified by differential amplifier 6 and led to an output terminal 12.

The output playback signal of first buffer transistor 5 is sent back to the base of grounded-emitter transistor 3 through a second buffer transistor 13 and feedback resistor 14 forming a negative feedback to return all components of the original signal, including Dc and AC components, without any variation. Thus, input impedance of the base of grounded-emitter transistor 3 is kept constant so as to amplify the playback signal with a flat frequency characteristic.

However, a major problem of this circuit is that a capacitor 10 of smoothing circuit 11 must be attached to the IC from outside and thereby increasing the number of pins of the IC. When the head amplifier of Fig.2 is used with a four-head VTR, four such circuits are needed and the complication of external capacitors and extra pins are remarkable. In the circuit of Fig.2, emitter voltage of first buffer transistor 5 is determined by V_{BE} (base-emitter voltage) of grounded-emitter transistor 3, voltage drop of feedback resistor 14, and V_{BE} of second buffer transistor 13; V_{BE} varies from IC to IC because of the dispersion of IC production process. Thus, the emitter voltages of first buffer transistor 5 may vary and bias voltage of transistor 8 must follow this variation, thereby necessitating the use of smoothing circuit 11. If the bias voltage applied to the base of transistor 8 is fixed, the fluctuation of the emitter voltage of first buffer transistor 5 causes an offset to differential amplifier 6 and the weak playback signal is distorted.

Further, for a home VTR, unnecessary signals in the playback signal must be eliminated. An example of such unnecessary signals is leaked RF switching pulses (30Hz) occurring when signals from two rotating heads are switched.

### DISCLOSURE OF THE INVENTION

The present invention, as it is defined in Claim 1, comprises an amplifier means which inputs a playback signal from a head, a differential amplifier means which inputs an output of the amplifier means and a reference voltage, a comparator means comparing the output of the amplifier means with the reference voltage, and a feedback means returning an output of the comparator means. An offset between two inputs to the differential amplifier means becomes zero by feeding back the output of the comparator to the amplifier means.

Furthermore, the present invention, as it is defined in Claim 5, has a means giving a frequency characteristic to a feedback path that includes the comparator means and the feedback means. By this means noise in the playback signal is eliminated.

### BRIEF DESCRIPTION OF THE DRAWINGS

Fig. 1 is a circuit diagram according to an embodiment of the invention.

Fig.2 is a circuit diagram of the prior art.

Fig.3 is a diagram representing frequency characteristics of the circuit of Fig.2.

Fig.4 is a diagram representing frequency characteristics of the circuit of Fig.1.

### THE BEST MODE FOR CARRYING OUT THE INVENTION

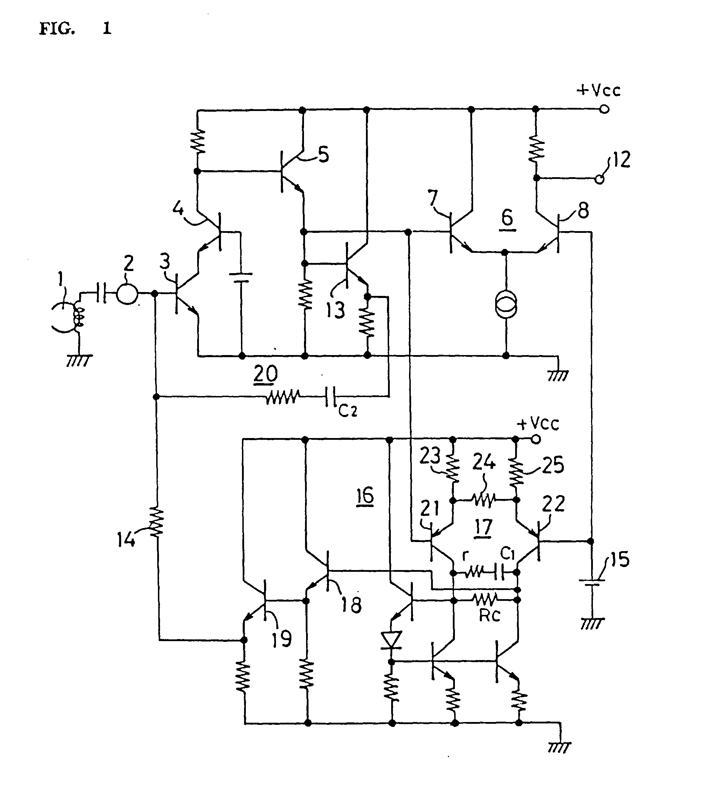

In Fig.1 an embodiment according to the invention is disclosed. Numeral 15 is a power source, numeral 16 is a feedback circuit to compare an output of a first buffer transistor 5 with the level of power source 15, and numeral 20 is a high-pass filter to feedback a high-frequency component in the output signal of a second buffer transistor 13 to a grounded-emitter transistor 3. Feedback circuit 16 comprises a differential amplifier 17, the output level of which changes according to the frequency of output signal of first buffer transistor 5, and third and fourth buffer transistor 18 and 19.

Under a non-signal condition, the emitter voltage of first buffer transistor 5 or base voltage of a transistor 7, are compared with the reference voltage from power source 15 by a transistor 21 and transistor 22 of differential amplifier 17. When base voltage of transistor 21 is higher than that of transistor 22, collector voltage of transistor 22 increases and, through third buffer transistor 18, emitter voltage of fourth buffer transistor 19 increases. The base voltage of grounded-emitter transistor 3 increases, collector voltage of a grounded-base transistor 4 decreases, thus forcing emitter voltage of first buffer transistor 5 to decrease. Eventually, the emitter voltage of first buffer transistor 5 is modulated to settle down to the same level as the reference voltage of power source 15; that is, a negative feedback loop is formed. Since the reference voltage of power source 15 is also applied to the base of a transistor 8, base voltage levels of transistor 7 and 8 are always equivalent in direct current sense; hence, offset level is maintained at zero and a differential amplifier 6 amplifies alternating-current signal coming from first buffer transistor 5 without distortion.

A combined resistance R_{E}, comprising resistors 23, 24, and 25 on the emitter side of differential amplifier 17, has a smaller resistance than that of a resistor R_{C} on the collector side. Combined resistance R_{E} has the same resistance as a resistor r. A capacitor C₁ has a capacity of about 50 pF which is small enough to be installed in an IC.

An effective frequency band of video playback signal is between 100KHz and 10MHz as shown in Fig.3 and level of the playback signal must be kept constant within that band. In the present invention, the playback signal is regenerated with a constant gain over the frequency range 100KHz through 10MHz while it is regenerated with a smaller gain for the frequencies smaller than that range, thereby preventing regeneration of unnecessary signals.

Referring to Fig.1, when a playback signal with frequency under 100KHz is applied to an input pin 2, the playback signal is compared with the reference voltage of power source 15. In this case, the gain of differential amplifier 17 is quite large because the gain is determined by the ratio R_{C}/R_{E}; therefore, a signal having the same frequency but a larger amplitude than the playback signal is generated at the collector of transistor 22 and is output to the emitter of fourth buffer transistor 19. Since a feedback resistance 14 in Fig.1 is equivalent to that in Fig.2, when the amplified feedback signal is generated at the emitter of fourth buffer transistor 19, an amount of negative feedback to the base of grounded-emitter transistor 3 becomes large and therefore an input impedance to the base is smaller than that of Fig.2. As the input impedance gets small, the level of playback signal lowers as shown in Fig.4. Since high-pass filter 20 does not permit the playback signal to pass, the function of the entire circuit is not affected.

When the frequency of the playback signal begins to increase, the gain of differential amplifier 17 starts dropping since serial circuit of resistor r and capacitor C₁ becomes resistance of differential amplifier 17 on collector side. The level of feedback signal which applies to the base of grounded-emitter transistor 3 then lowers, thereby causing its input impedance to increase and the level of playback signal to increase as shown in Fig.4. When the frequency of playback signal further increases and enters the effective frequency band the impedance of transistor 21 and transistor 22 on the collector side is determined only by resistor r and therefore the gain of differential amplifier 17 becomes 1 and the level of playback signal is unchanged at the emitter of fourth buffer transistor 19. Since feedback resistor 14 in Fig. 1 is equivalent to feedback resistor 14 in Fig.2, the circuit in Fig.1 functions in the same way as the circuit in Fig.2; that is, input impedance of grounded-emitter transistor 3 remains constant. While the input impedance remains constant, the level of playback signal also remains constant as shown in Fig.4. The signal does not alter the output DC voltage of first buffer transistor.

Since of a high-pass filter 20 has a high cut-off frequency with a capacitor C₂ of 50 to 60 pF, very few playback signals can pass the filter if the signal has a frequency within the effective band.

Consequently, the circuit in Fig.1 is able to amplify the playback signal within the effective band without help of an outside capacitor.

Referring to Fig.4, the playback signals with frequencies under the effective band are reduced to eliminate unnecessary signals (such as 30Hz PG pulses for a servo circuit) occurring in this frequency band.

Differential amplifier 17 in Fig.1 uses a PNP transistor; however, this transistor sometimes exhibits an insufficient response characteristic inducing phase distortion which causes unfavorable behavior of the playback signal level as shown in Fig.4 with doted line, resulting in an improper negative feedback. In the present invention, in order to compensate this disadvantage, high-pass filter 20 is installed and feedback takes place through another loop when the frequency of playback signal exceeds a certain limit, thus keeping constant the input impedance of grounded-emitter transistor 3 even if a PNP transistor is used in feedback circuit 16.

### POSSIBILITY FOR INDUSTRIAL USE

Accordingly, a head amplifier of the present invention requires very few outside parts and small number of pins, and therefore is very useful as a head amplifier to be installed in an IC.

## Claims

1. A head amplifier comprising:
an amplifier means (3,4,5) inputting a playback signal from a magnetic head;
a differential amplifier means (6) inputting an output of said amplifier means and a reference voltage (15);
a comparator means (17) comparing the output of said amplifier means with said reference voltage;
a feedback means (16,14) returning an output of said comparator means to an input of said amplifier means; and
said head amplifier outputting a playback signal amplified by said differential amplifier.

2. The head amplifier according to claim 1, wherein:
a frequency characterization means providing a frequency characteristic to a feedback loop path including said comparator means (17) and said feedback means (16).

3. The head amplifier according to claim 1, wherein:
a pair of transistors (21,22) forming a differential amplifier; and
a serial circuit of a capacitor (C₁) and a resistor (r) on the collector side of said pair of transistors (21,22).

4. The head amplifier according to claim 1 or claim 2 comprising
a high-pass filter (20) receiving an output of said amplifier means, said high-pass filter compensating a high frequency characteristic of said feedback loop.

5. A head amplifier comprising:
an amplifier means amplifying (3,4,5) a playback signal from a head;
a differential amplifier means (6) amplifying the difference between an output signal of said amplifier means and a reference voltage (15);
a feedback circuit means (17) comparing the output of said amplifier means with said reference voltage and outputting a signal amplified by a high gain when the frequency of the output of said amplifier means is lower than an effective frequency band of playback video signal and outputting a signal amplified by a smaller gain than said high gain when the frequency of the output of said amplifier means is higher than said effective frequency band;
a feedback resistor (14) leading the output signal of said feedback circuit means to an input of said amplifier; and
said amplifier means outputting a playback signal amplified by said differential amplifier means.

## Patentansprüche

1. Kopfverstärker mit
einem Verstärkermittel (3, 4, 5), dem von einem Magnetkopf ein Wiedergabesignal eingegeben wird,
einem Differenzverstärkermittel (6), dem die Ausgabe des Verstärkermittels und eine Bezugsspannung (15) eingegeben werden,
einem Vergleichsmittel (17), das die Ausgabe des Verstärkermittels mit der Bezugsspannung vergleicht,
einem Rückkoppelungsmittel (16, 19), das die Ausgabe des Vergleichsmittels an den Eingang des Verstärkermittels zurückführt,
wobei der Kopfverstärker ein Wiedergabesignal ausgibt, das durch den Differenzverstärker verstärkt wurde.

2. Kopfverstärker nach Anspruch 1,
mit einem Frequenzcharakterisierungsmittel, das dem Rückkopplungsschleifenweg einschließlich des Vergleichsmittels (17) und des Rückkopplungsmittels (16) eine Frequenzcharakteristik gibt.

3. Kopfverstärker nach Anspruch 1,
mit einem Paar Transistoren (21, 22), die einen Differenzverstärker bilden, und einer Reihenschaltung eines Kondensators (C₁) und eines Widerstands (r) an der Kollektorseite des Transistorpaares (21, 22).

4. Kopfverstärker nach Anspruch 1 oder 2,
mit einem Hochpaßfilter (20), der die Ausgabe des Verstärkermittels erhält, wobei das Hochpaßfilter die Hochfrequenzcharakteristik der Rückkoppelungsschleife kompensiert.

5. Kopfverstärker mit:
einem Verstärkermittel (3, 4, 5), das ein Wiedergabesignal von einem Kopf verstärkt,
einem Differenzverstärkermittel (6), das die Differenz zwischen dem Ausgabesignal des Verstärkermittels und einer Bezugsspannung (15) verstärkt,
einem Rückkoppelungsschaltungsmittel (17), das die Ausgabe des Verstärkermittels mit der Bezugsspannung vergleicht und ein mit einem hohen Verstärkungsfaktor verstärktes Signal ausgibt, wenn die Frequenz der Ausgabe des Verstärkermittels geringer ist als das effektive Frequenzband eines Wiedergabe-Videosignals, und ein mit einem geringeren Verstärkungsfaktor als der hohe Verstärkungsfaktor verstärktes Signal ausgibt, wenn die Frequenz der Ausgabe des Verstärkungsmittels höher ist als das effektive Frequenzband,
einem Rückkoppelungswiderstand (14), der das Ausgangssignal des Rückkoppelungsschaltungsmittels zum Eingang des Verstärkers leitet,
wobei das Verstärkermittel ein durch das Differenzverstärkermittel verstärktes Wiedergabesignal ausgibt.

## Revendications

1. Amplificateur de tête comprenant : un moyen d'amplificateur (3, 4, 5) recevant un signal de restitution provenant d'une tête magnétique ;
un moyen d'amplificateur différentiel (6) recevant une sortie dudit moyen d'amplificateur et une tension de référence (15) ;
un moyen de comparateur (17) comparant la sortie dudit moyen d'amplificateur à ladite tension de référence ;
un moyen de contre-réaction (16, 14) renvoyant une sortie dudit moyen de comparateur à une entrée dudit moyen d'amplificateur ; et
ledit amplificateur de tête sortant un signal de restitution amplifié par ledit amplificateur différentiel.

2. Amplificateur de tête selon la revendication 1, dans lequel :
un moyen de caractérisation en fréquence procurant une caractéristique de réponse en fréquence à un trajet de boucle de contre-réaction comprenant ledit moyen de comparateur (17) et ledit moyen de contre-réaction (16).

3. Amplificateur de tête selon la revendication 1, dans lequel :
une paire de transistors (21, 22) forme un amplificateur différentiel avec un circuit série constitué d'un condensateur (C₁) et d'une résistance (r) sur le côté collecteur de ladite paire de transistors (21, 22).

4. Amplificateur de tête selon la revendication 1 ou la revendication 2 comprenant
un filtre passe-haut (20) recevant une sortie dudit moyen d'amplificateur, ledit filtre passe-haut compensant une caractéristique de réponse en fréquence haute de ladite boucle de contre-réaction.

5. Amplificateur de tête comprenant :
un moyen d'amplificateur (3, 4, 5) amplifiant un signal de restitution provenant d'une tête ;
un moyen d'amplificateur différentiel (6) amplifiant la différence entre un signal de sortie dudit moyen d'amplificateur et une tension de référence (15) ;
un moyen de circuit de contre-réaction (17) comparant la sortie dudit moyen d'amplificateur à ladite tension de référence et sortant un signal amplifié avec un gain élevé lorsque la fréquence de la sortie dudit moyen d'amplificateur est inférieure à une bande de fréquence effective d'un signal vidéo de restitution et sortant un signal amplifié avec un gain plus faible que ledit gain élevé lorsque la fréquence de la sortie dudit moyen d'amplificateur est supérieure à ladite bande de fréquence effective ;
une résistance de contre-réaction (14) conduisant le signal de sortie dudit moyen de contre-réaction à une entrée dudit amplificateur ; et
ledit moyen d'amplificateur sortant un signal de restitution amplifié par ledit moyen d'amplificateur différentiel.
